# EUROPEAN PATENT APPLICATION

(11) **EP 2 620 461 A1**
(43) Date of publication of application: **31.07.2013**
(21) Application number: 12152234.6
(22) Date of filing: 24.01.2012
(51) Int. Cl.: C08G 61/02, G01N 21/64, H05B 33/08

(54) **Amphiphilic polymers functionalized with glucose or a derivative thereof**

(71) Applicant: Synchimia S.r.l., 70125 Bari (IT)
(72) Inventor: Iacobelli, Giuliano, 70013 Castellan Grotte (IT); Naso, Francesco, 70128 Bari (IT); Farinola, Gianluca Maria, 70124 Bari (IT)
(74) Representative: Fiume, Orazio

(57) **Abstract**

Amphiphilic polymers functionalized with glucose or derivatives thereof are described, in particular poly(p-phenylene ethynylene) substituted by a molecule of glucose or a derivative thereof. Said polymers find advantageous use in the field of fluorescence-quenching optical sensors or in the field of OLEDs (*Organic Light Emitting Diodes*)*.*

## Description

### FIELD OF THE INVENTION

This invention concerns amphiphilic polymers functionalized with glucose or derivatives thereof, in particular poly(p-phenylene ethynylene) substituted by a molecule of glucose or a derivative thereof. Such polymers find advantageous use in the field of fluorescence-quenching optical sensors or in the field of OLEDs (*Organic Light Emitting Diodes*).

### STATE OF THE ART

The poly(p-phenylene ethynylene) are polymers wherein an extensive conjugated system is present, which provides them with interesting optical properties such as a high quantum yield for their fluorescence in solutions and solvatochromism, thus allowing their use in the field of fluorescence quenching optical sensors.

The functional principle of fluorescence quenching optical sensors comprising poly(p-phenylene ethynylenes) is based on the extensive conjugation of the p orbitals of the hybridized sp² carbon atoms and on the presence of triple bonds as the fundamental units bonding the individual parts of the polymer. Due to such features, the free transfer of excitons (electron/hole pairs) is possible within the polymer itself. This migration allows, after the stimulation of the polymer by light at a suitable wavelength, even tiny traces of suitable molecules named quenchers, capable of bonding to the polymer itself, to drastically reduce the photoluminescence quantum yield of this type of polymers.

One of the main problems, under this point of view, is the so-called "self-quenching" of the polymer, which especially in the solid state, is the most probable phenomenon. In order to avoid this problem, very bulky substituents are used so as to give an effective spacing between the polymer molecules. However, such "spacer" groups have not shown to be completely satisfactory and moreover, they are generally obtained from toxic compounds.

Therefore, it is an object of the present invention to provide polymers that maintain high optical properties, but at the same time show a self-quenching risk as low as possible and are not toxic.

### SUMMARY OF THE INVENTION

The object above has been achieved by a polymer having formula (I): 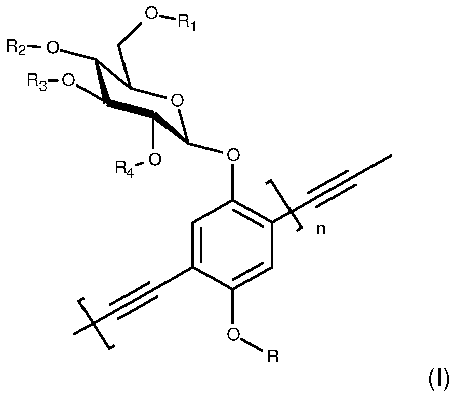 an enantiomer, or a diastereoisomer thereof,
wherein n is an integer higher than 2,
R is a linear or branched C₁-C₂₀ alkyl group, and
R₁, R₂, R₃, R₄ are, independently of each other, H, a linear or branched alkyl C₁-C₃ group or acetate (Ac).

Surprisingly, it has been found in fact that said polymer shows a high photoluminescence quantum yield as a film, due to the amphiphilic polymer structure based on the polar groups of the glucose moiety. In particular, a high level of sensitivity to trinitro-toluene (TNT) was observed.

Thus, in another aspect, the present invention concerns the use of the polymer of formula (I) in fluorescence quenching sensors, particularly for the detection of TNT.

In a further aspect, the invention also concerns the use of the polymer of formula (I) in organic light-emitting electroluminescent devices (OLEDs).

In a yet further aspect, the present invention concerns a process for the preparation of the polymer of formula (I).

### BRIEF DESCRIPTION OF THE DRAWINGS

The characteristics and advantages of the present invention will be evident from the following detailed description, the working examples provided for illustrative purposes, and the attached Figures, wherein:
- Figure 1 is a diagram showing a comparison among quenching isotherms for films having the same absorbance and substrate (glass) when exposed to the vapour pressure of trinitrotoluene (TNT) and dinitrotoluene (DNT), as per Example 3; and
- Figure 2 is the fluorescence intensity trend recorded at the maximum emission of 475 nm of a polymer film excited by light at 420 nm, as per Example 3, during exposure to vapours produced by 1µg of TNT in a closed cuvette.

### DETAILED DESCRIPTION OF THE INVENTION

The subject of the present invention is, therefore, a polymer having formula (I): 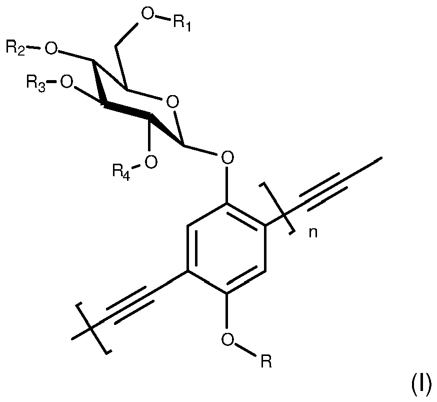 an enantiomer, or a diastereoisomer thereof,
wherein n is an integer higher than 2,
R is a linear or branched C₁-C₂₀ alkyl group, and
R₁, R₂, R₃, R₄ are, independently of each other, H, a C₁-C₃ alkyl group, or acetate (Ac).

Surprisingly, it has been found in fact that said polymer shows a high photoluminescence quantum yield as a thin film, due to the amphiphilic polymer structure based on the polar groups of the glucose moiety, as will be also shown by the Examples and the attached Figures, but especially said glucose moiety is a non-toxic substituent, differently those used in the known state of the art. Preferably, n is an integer higher than 6. According to an embodiment, n is 8. Preferably, in said polymer, R is a linear or branched C₁-C₁₆ alkyl group.

More preferably, in said polymer, R is a linear or branched C₁-C₁₂ alkyl group. According to a first preferred embodiment of the present invention, the polymer has formula (Ia):

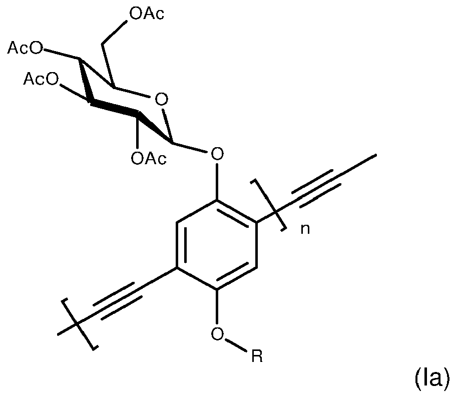

Particularly preferred is the polymer of formula (1a):

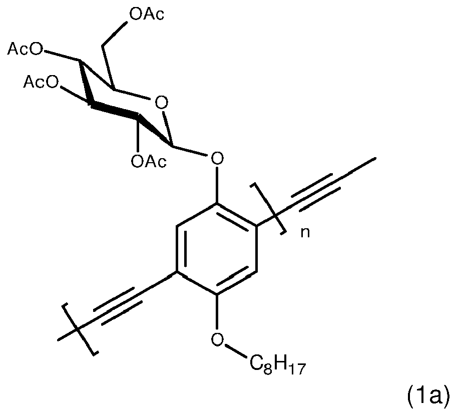

In fact, as will be shown by the Examples and the attached Figures, the polymer of formula (1a) has showed to be particularly suitable for the detection of TNT and thus for use in sensors for said application.

Alternatively, the polymers of formula (2a) and (3a) are preferred:

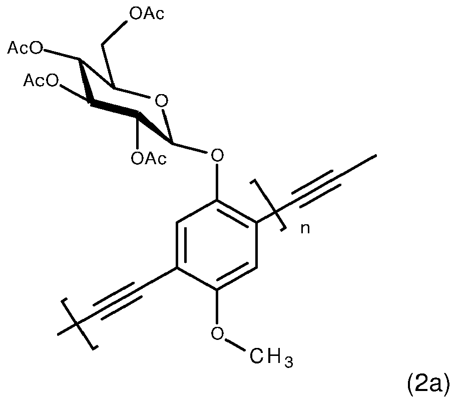

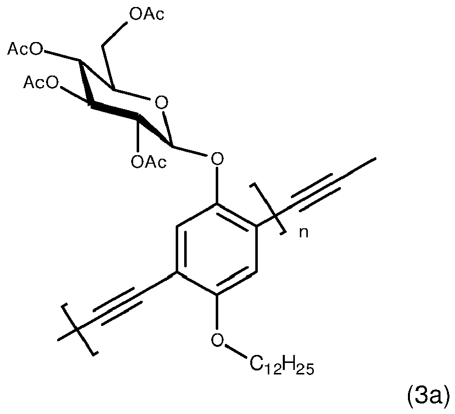

According to another preferred embodiment of the present invention, the polymer has formula (Ib):

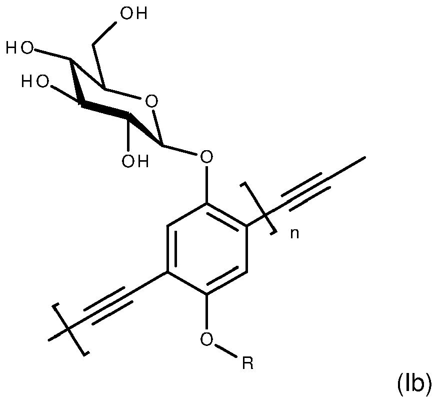

Particularly preferred is the polymer of formula (1b):

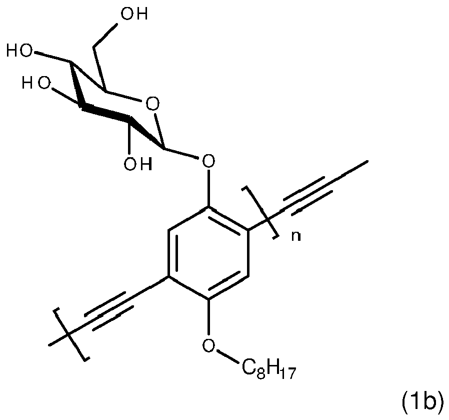

Alternatively, the polymers of formula (2b) and (3b) are preferred:

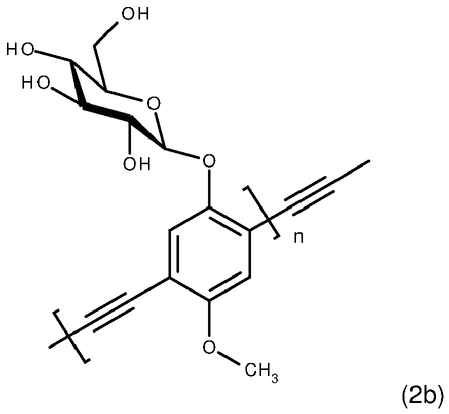

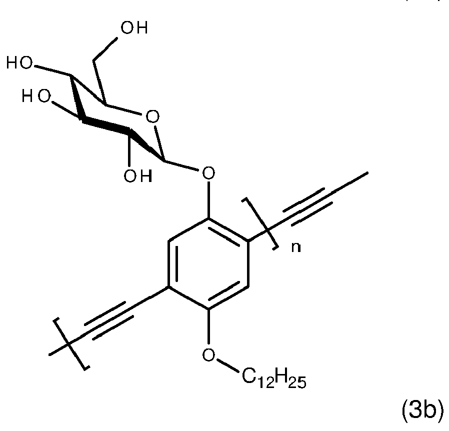

According to a further preferred embodiment of the present invention, the polymer has formula (Ic):

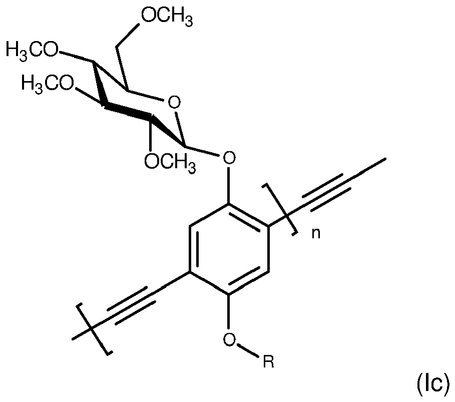

The polymers of formula (1c), (2c) and (3c) are particularly preferred:

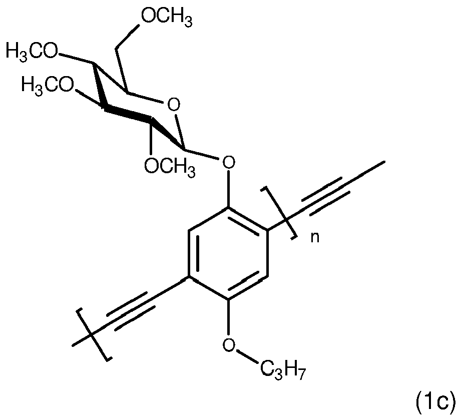

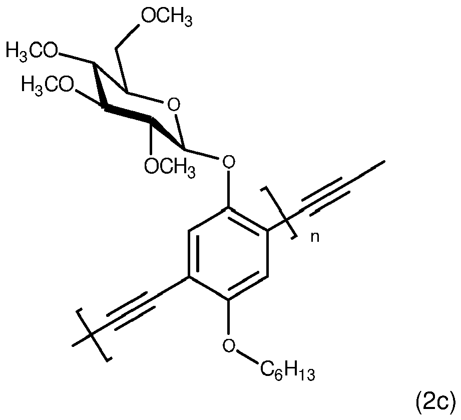

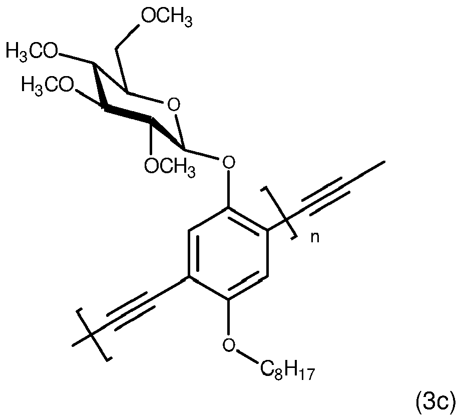

In another aspect, the present invention concerns the use of the polymer of formula (I) in fluorescence quenching sensors. Specifically, said use concerns fluorescence-quenching sensors for the detection of TNT.

Therefore, the subject of the present invention also includes fluorescence-quenching sensors comprising a film of the polymer of formula (I) and a suitable substrate.

Such sensors are prepared by depositing a solution of the polymer of formula (I) in a suitable polar solvent such as N,N-dimethylformamide (DMF), on the substrate, which may be a thin glass sheet or glass spherules. The latter are preferable, since they increase the surface exposed to the vapours from the explosive.

Such a deposition is carried out preferably by spin-coating until a film 100-500 nm thick, preferably 200-400 nm thick, is obtained.

In a further aspect, the present invention concerns the use of the polymer of formula (I) in organic light-emitting electroluminescent devices (OLEDs).

Therefore, the subject of the present invention also includes organic light-emitting electroluminescent devices (OLEDs) comprising an electroluminescent film of the polymer of formula (I) deposited on a transparent conducting electrode (e.g. ITO, i.e. *Indium Tin Oxide*) in the presence of suitable components capable to inject electrons or holes (*electron transporting layer, hole transporting layer*)*.*

In a yet another aspect, the present invention concerns a process for the preparation of the polymer of formula (I) described above, comprising the steps of:
i) iodinating the dialkyloxybenzene of formula (A): 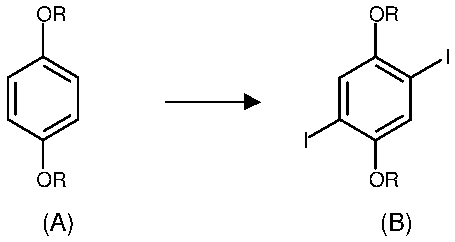
ii) selectively monodealkylating with boron tribromide: 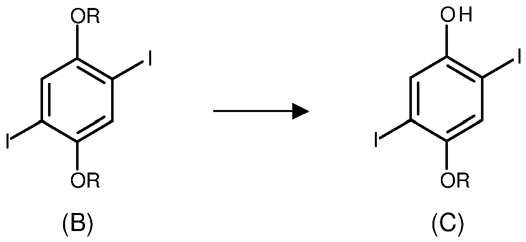
iii) silylating and subsequently reacting with glucose or a derivative thereof: 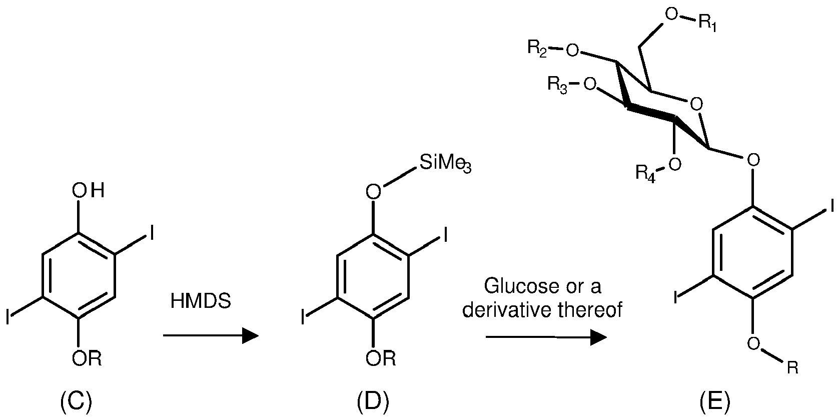
iv) Sonogashira cross-coupling with trimethylsilylacetylene (TMSA): 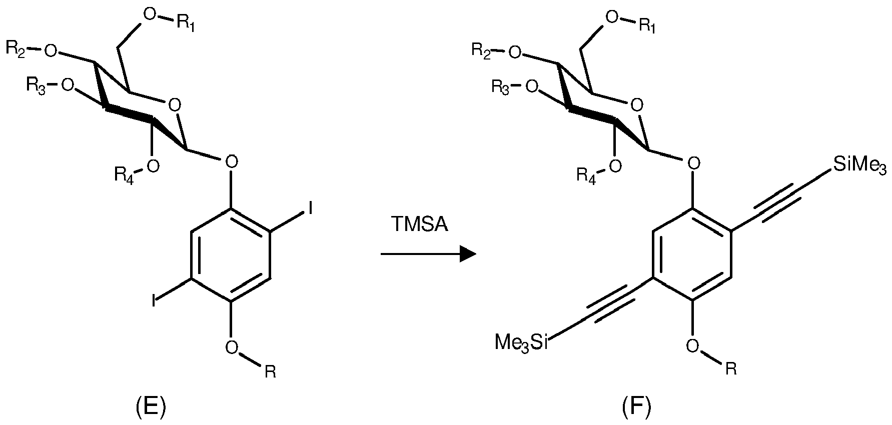
v) polymerizing in the presence of silver oxide to obtain the polymer of formula (I):

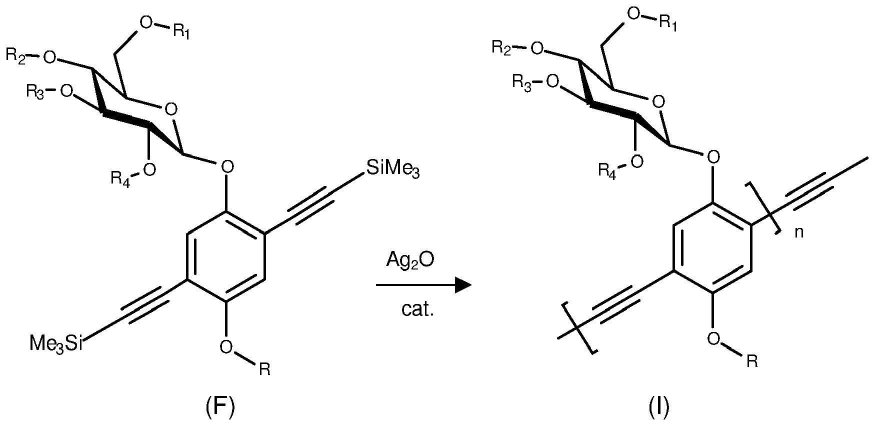

Preferably, in said step (v), tetrakis(triphenylphosphine)palladium (Pd[PPh₃]₄) is used as a catalyst.

Alternatively, it is possible to obtain the polymer of formula (Ia), wherein R₁ = R₂= R₃ = R₄ = acetate (Ac), in accordance with the process described above, and subsequently, to carry out a step (vi) of deacetylation in methanol, thus obtaining the polymer of formula (Ib), wherein R₁ = R₂= R₃ = R₄ = H.

Subsequently, said polymer of formula (Ib) may be alkylated, thus obtaining the polymer wherein R₁ = R₂= R₃ = R₄ = C₁-C₃ alkyl group. In particular, when the polymer of formula (Ib) is subjected to a methylation reaction, the polymer of formula (Ic) is obtained.

It should be understood that all the characteristics identified as preferred and advantageous for the polymer are likewise preferred and advantageous for the process of preparing the polymer and for its uses, as well as for the sensor and the organic electroluminescent light-emitting device (OLED) of the present invention.

Working examples of the present invention are provided herein below for illustrative purposes.

### EXAMPLES

In the Examples, the following abbreviations have been adopted:

AcOH (acetic acid), br (broad), comp (complex), concd (concentrated), d (doublet), DCM (dichloromethane); dH₂O (de-ionized water Nanopure), EA (ethyl acetate), DMF (N,N-dimethylformamide), EI-MS (electronic impact mass spectrometry); EtOH (ethanol); Et₃N (triethylamine), h (hours), m (multiplet); mp (melting point); MeCN (acetonitrile); MeOH (methanol), min (minute), NMR (nuclear magnetic resonance), p (quintuplet), PE (petroleum ether), q (quartet), quint (quintet); Rf (retention coefficient); rt (room temperature); s (singlet), Sat (saturated); t (triplet), TFA (trifluoroacetic acid); THF (tetrahydrofurane); MTAS (Trimethylsilylacetylene); TMSCI (trimethylsilyl chloride).

*Materials and Methods.* The melting points were recorded on a Gallenkamp Melting Point apparatus. The gas chromatography analyses were performed on a gas chromatograph with a type SE-30 capillary column (polydimethyl silicone, 30 m × 0,25 mm). The molecular masses were determined with high-performance liquid chromatography on a Hewlett-Packard HP 1050 with THF as a solvent using a 5µ Plgel Mixed-D 300 x 7.5 mm column. The ¹H and ¹³C-NMR spectra were obtained on a NMR Varian Inova (400 MHz) spectrometer using the solvent as an internal point of reference. The NMR data were displayed as follows: chemical shift, multiplicity, coupling constant, integration constant. The mass spectra were recorded on a Thermo POLARIS Q GC-MS (EI-lon trap). The FT-IR data were recorded on a PerkinElmer Spectrum BX and the elemental analysis was performed on a CARLO ERBA CHNS-O. All the reagents and solvents commercially available from Alfa Aesar, Aldrich, and Fluka and were used without any further purification.

The commercial solvents CH₂Cl₂, THF, and CH₃CN were purified through distillation using phosphorus pentoxide, sodium, and molecular sieves 4Å, respectively. All reactions were carried out under N₂.

The chromatographic substrate for the preparatory chromatography consisted of Flash MN (Macherey-Nagel) Kieselgel 60 M (0.040-0.063 mm) silicon dioxide powder. For quantitative analyses, silicon dioxide placed on thin (0.2 mm) TLC (MN Alugram Sil G/UV254) was used; with these, the progress of the reaction was monitored, while the visualizations were carry out by using a UV illuminator or through permanent stabilization with a solution of H₂SO₄ 10%, phosphomolybdic acid / EtOH.

### Example 1. Preparation of the polymer of formula (1a) of the invention

The preparation and the characterization of the polymer of formula (1a) is reported herein below:

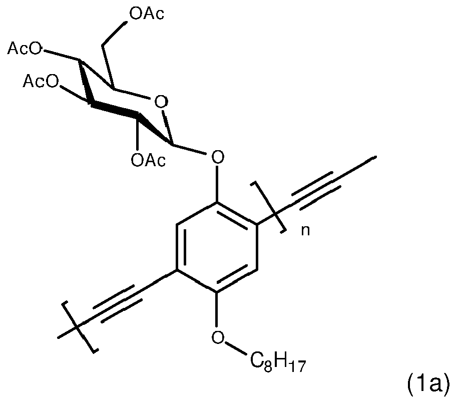

### - Synthesis of 2,5-diiodo-1,4-bis(n-octyloxy)benzene:

Iodination of the 1,4-bis-n-octyloxybenzene (5g) compound was carried out through a reaction with I₂, HIO₃ in a solution of acetic acid, methylene chloride, and sulphuric acid, in accordance with the procedure in the literature (Z. Bao, Y. Chen, R. Cai and L. Yu, Macromolecules 1993, 26, 5281).

Thus, 7 g of 2,5-diiodo-1,4-bis(n-octyloxy)benzene were obtained (70% yield).
¹H-NMR (400 MHz, CDCl₃) (ppm): 7.35 (s, 2H), 4.01 (t, 4H), 1.88 (quint, 4H), 1.58 (quint, 4H) 1.35 (comp, 10H), 0.97 (t, 6H)

### - Synthesis of 2,5-diiodo-4-n-octyloxy phenol:

2,5-diiodo-1,4-bis(n-octyloxy)benzene (3.5 g, 5.97 mmol) was dissolved in anhydrous CH₂Cl₂ (60 ml) and then 4.8 mL of BBr₃ 1M solution were added dropwise at 0 °C. The resulting solution was reacted under stirring at the same temperature for 50 min. Then a 10% HCl solution was added slowly to the reaction mixture; after that, an extraction was performed with EA (250 +250 ml), the organic phase was separated and anhydrified on Na₂SO₄, and finally evaporated to dryness (rotavapor). After low-pressure evaporation of the solvent, the crude product was purified through silicon dioxide gel chromatography, by using a PE/EA (9:1) solution as the eluent, thus obtaining 2.68 g (95% yield) of solid 2,5-diiodo-4-n-octyloxy phenol.
mp: 55 ÷ 57 °C
Rf = (1:9 EA / PE) 0.67
¹H-NMR (400 MHz, CDCl₃) (ppm): 0.88 (t, J = 6.9 Hz, 3.2 H), 1.29 (comp, 8.6 H), 1.49 (quint, J = 8 Hz, 2 H), 1.8 (quint, J = 8 Hz, 2.1 H), 3.9 (t, J = 6.59, 2.1 H), 4.94 (s, 1 H), 7.02 (s, 1.1 H), 7.4 (s, 1 H)
¹³C-NMR (100 MHz, CDCl₃) (ppm): 14.4, 22.9, 26.3, 29.3, 29.4, 29.5, 32.0, 70.6, 84.6, 87.8, 121.1, 125.0, 150.0, 152.8
IR (KBr) (cm⁻¹): 3238, 2916, 2850, 1486, 1470, 1408, 1392, 1276, 1204, 1050, 1026,858,794,722,434
EI-MS (M / Z): 475 (M +1, 7%), 474 (M +, 25%), 363 (18%), 362 (100%)
ESI-MS (M / Z): Calculated: 496.9450 (M + Na); Found: 496.9445 (M + Na)

### - Synthesis of (4-n-octyloxy-2,5-diiodo-phenoxy)-trimethyl-silane:

2,5-Diiodo-4-n-octyloxy phenol (1.144 g, 2.4 mmol), trimethyl chlorosilane (336 µl, 2.6 mmol) and 1,1,1,3,3,3-hexamethyldisilazane (550 µl, 2.6 mmol) were dissolved in 6 ml of anhydrous acetonitrile. The reacting mixture was mixed under nitrogen at room temperature for 16 h and then the solvent was removed under low pressure. The residue was dissolved in petroleum ether and filtered in order to eliminate the precipitated salts. The solution was washed with an aqueous solution saturated with bicarbonate and sodium chloride; then, the organic extracts were dried on anhydrous Na₂SO₄ and left to dry. The product was 1.25 g (95% yield) of (4-n-octyloxy-2,5-diiodo-phenoxy)-trimethylsilane, which required no further purification.
¹H-NMR (500 MHz, CDCl₃) (ppm): 0.30 (s, 8.9 H), 0.89 (t, J = 7.1 Hz, 3.1 H), 1.29 (comp, 8.7), 1.49 (quint, J = 7.5, 2.5 H), 1.8 (quint, J = 7.9, 2.0 H), 3.9 (t, J = 6.3 Hz, 2.3 H), 7.1 (s, 1 H), 7.2 (s, 0.9 H)
¹³C-NMR (100 MHz, CDCl₃) (ppm): 0.69, 14.3, 22.88, 26.2, 29.3, 29.4, 32.0, 70.3, 86.3, 90.4, 122.0, 128.8, 150.1, 153.4
IR (KBr) (cm⁻¹): 2924, 2854, 1536, 1456, 1386, 1350, 1296, 1254, 1210, 1126, 1050, 1020, 942, 868, 756, 708, 668, 570, 440
EI-MS (M / Z): 547 (M +1, 13%), 446 (M +, 60%), 435 (14%), 434 (100%), 419 (94%), 292 (42%), 180 (8%), 73 (8%)
ESI-MS (M / Z): Calculated: 568.9846 (M + Na +); Found: 568.9840 (M + Na +)

### - Synthesis of (2,3,4,6-tetra-0-acetyl-β-D-glucopyranosyl)-2,5-diiodo-4-n-octyloxybenzene:

BF3 • Et₂O (2.1 ml) was added to a solution of (4-n-octyloxy-2,5-diiodo-phenoxy)-trimethylsilane (1.2 g, 2.2 mmol) in 10 ml of CH₂Cl₂ under nitrogen. Subsequently, a solution of β-D-glucose pentaacetate (0.920 g, 2.42 mmol) in 25 ml of anhydrous dichloromethane was added. After 16 h at rt, the reaction mixture was washed with a saturated bicarbonate solution and the organic extracts were anhydrified on anhydrous Na₂SO₄. After low-pressure evaporation of the solvent, (2,3,4,6-tetra-O-acetyl-β-D-glucopyranosyl)-2,5-diiodo-4-n-octyloxybenzene was purified by methanol crystallization, to obtain 1.1 g (55% yield) of the product in white solid form.
mp: 128-130 °C
Rf = (3:7 EA / PE) 0.75
¹H-NMR (400 MHz, CDCl₃) (ppm): 0.88 (t, J = 6.6 Hz, 3.1 H), 1.28 (comp, 8.1 H), 1.48 (quint, J = 8.0, 1.8 H), 1.79 (quint, J = 7.3, 1.9 hours), 2.01, 2.05, 2.1, 2.17 (s, 11.9 H), 3.9 (comp, 3 H), 4.2 (comp, 2.0) 4.91 (d, J = 7.3, 0.9 H), 5.1 (comp, 0.9 H), 5.29 (comp, 1.9), 7.11 (s, 1.0 H), 7.48 (s, 1.0 H)
¹³C-NMR (100 MHz, CDCl₃) (ppm): 14.3, 20.8, 21, 28, 22.8, 26.2, 29.2, 29.4, 31.98, 62.47, 68.53, 70.32, 70.9, 72.5, 72.8, 86.3, 86.94, 100.5, 122.1, 127.2, 150.8, 154.9, 169.4, 169.6, 170.4, 180.0
IR (KBr) (cm⁻¹): 2922, 2852, 1738, 1480, 1460, 1378, 1352, 1258, 1222, 1088, 1052,914,878,600
ESI-MS (M / Z): Found: 827.0401 (M + Na); Expected: 827.0396 (M + Na)

### - Synthesis of (2,3,4,6-tetra-O-acetyl-β-D-glucopyranosyl)-2,5-bis (trimethylsilyl ethynyl)-4-n-octyloxybenzene:

(Trimethylsilyl) acetylene (372 µl, 2.63 mmol) and triethylamine (820 µl, 5.86 mmol) were added at room temperature to a stirred solution of (2,3,4,6-tetra-O-acetyl-β-D-glucopyranosyl)-2,5-diiodo-4-n-octyloxy-benzene 3 (0.6 g, 0.732 mmol) in 15 ml of anhydrous toluene. Then, Pd(PPh₃)₄ (0.042 g, 0.036 mmol) and Cul (0.015 g, 0.08 mmol) were added in that order. After 48 hours, the reaction mixture was extracted with dichloromethane, washed with saturated acqueous NH₄Cl, and the organic phase was anhydrified on anhydrous Na₂SO₄. After low-pressure evaporation of the solvent, the product was purified through silicon dioxide gel chromatography by using petroleum ether / ethyl acetate (8:2) as an eluent. 0.490 g (82% yield) of (2,3,4,6-tetra-O-acetyl-β-D-glucopyranosyl)-2,5-bis (trimethylsilyl ethynyl)-4-n-octyloxybenzene were obtained in the form of a yellow solid.
mp: 125-127 °C
Rf = (2:8 EA / PE) 0.29
¹H-NMR (400 MHz, CDCl₃) (ppm): 0.23 (s, 18.6 H), 0.86 (t, J = 6.6, 3.3 H), 1.27 (comp, 8.2 H), 1.48 (quint, J = 6.9, 2.3 H), 1.78 (quint, J = 7.3, 2.4 H), 2.0, 2.03, 2.1 (s, 12.2 H), 3.93 (comp, 3.2 H), 4.19 (comp, 2.3 H), 5.1 (comp, 2.2 H), 5.27 (comp, 2.1 H), 6.85 (s, 1.1 H), 6.98 (s, 1.1 H)
¹³C-NMR (100 MHz, CDCl₃) (ppm): 0.053, 14.29, 20.8, 20.98, 22.85, 26.2, 29.43, 29.48, 29.54, 32.03, 62.35, 68.58, 69.40, 71.13, 72.26, 73.05, 99.22, 99.81, 100.8, 101.1, 114.0, 115.0, 117.1, 119.6, 150.9, 155.8, 169.1, 169.6, 170.4, 170.8 IR (KBr) (cm⁻¹): 2958, 2930, 2858, 2156, 1750, 1500, 1368, 1222, 1080, 1036, 884,844,758,626
ESI-MS: calculated: 767.3259 (M + Na +) Found: 767.3253 (M + Na +)

### - Synthesis of polymer (1a):

(2,3,4,6-tetra-O-acetyl-β-D-glucopyranosyl)-2,5-diiodo-4-n-octyloxy-benzene (475 mg, 0.587 mmol), (2,3,4,6-tetra-O-acetyl-β-D-glucopyranosyl)-2,5-bis (trimethyl-silylethynyl)-4-n-octyloxybenzene (433 mg, 0.587 mmol), Ag₂O (271 mg, 1.17 mmol) and Pd (PPh₃)₄ (68 mg, 0.059 mmol) were dissolved in 25 ml of anhydrous THF under nitrogen. The mixture was stirred at 60°C for 72 hours. The obtained dark solution was filtered on celite in order to remove unreacted Ag₂O. After low-pressure evaporation of the solvent, the crude product was extracted for 6 hours with a Soxhlet extractor using methanol, so as to eliminate the low molecular weight fractions. The purified solid was then extracted with CHCl₃ and subjected to repeated centrifugation (10000 rpm, 20 min), thereby obtaining a yellow solution, which was subsequently concentrated at a low pressure, from which a vacuum-dried dark yellow solid was obtained. Therefore, 170 mg (86% yield) of polymer (1a) were obtained.
¹H-NMR (400 MHz, CDCl₃) δ (ppm): 0.833 (s, 3.3 H), 1.24 ÷ 1.55 (comp, 10 H), 1.85 ÷ 2.01 (comp, 12 H), 3.98 ÷ 4.6 (comp, 3.9 H), 5.0 ÷ 5.6 (comp, 3.5), 6.88 ÷ 7.4 (comp, 2 H)
¹³C-NMR (100 MHz, CDCl₃) (ppm): δ (ppm): 13.085, 19.591, 21.671, 24.914, 25.067, 28.354, 30.847, 60.713, 60.997, 61.287, 66.831, 67.460, 68.287, 68.491, 69.730, 70.554, 71.080, 71.765, 72.075, 89.688, 90.201, 90.309, 90.490, 91.035, 91.212, 91.417, 96.659, 97.258, 98.075, 98.901, 99.194, 112.636, 112.759, 113.097, 113.545, 114.850, 115.562, 116.009, 117.062, 118.624, 149.745, 149.907, 153.919, 154.398, 167.996, 168.453, 169.138, 169.349, 169.730, 170.132
IR (KBr) (cm⁻¹): 2956, 2856, 2208, 1760, 1514, 1428, 1370, 1224, 1042, 908, 892, 876,796,698,598,504,406

### Example 2. Preparation of the polymer of formula (1b) of the invention

The preparation and the characterization of the polymer of formula (1b) is reported herein below:

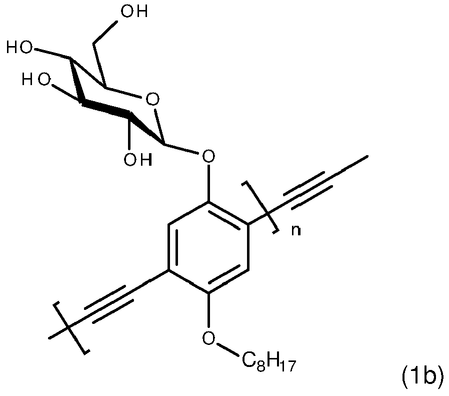

A catalytic amount of metallic sodium (5 mg, 5%) was reacted in 3 ml of MeOH until complete dissolution. Subsequently, the polymer (1a) (0.100 g) obtained in Example 1 was added. The suspension was reacted under stirring at room temperature for 96 hours, at the end of which a green precipitate was obtained. The latter was washed with cold MeOH; the solid was vacuum-dried and dissolved in 1.4 ml of DMF d-7 to obtain the centrifuged mother solution (10000 rpm, 20 min) of polymer (1b).
¹H-NMR (400 MHz, DMF-d7) δ(ppm): 0.868 (3.7 H), 1.29 (9.2), 1.56 (1.7 H), 1.87 (1.7 H), 3.43÷4.152 (14.9 H), 4.8÷5.4 (4.5 H), 7.1÷7.6 (4 H)
¹³C-NMR (100 MHz, DMF-d7) δ(ppm): 14.269, 23.090, 26.461, 26.624, 32.313, 32.384, 62.086, 62.255, 69.835, 70.969, 71.088, 74.686, 77.931, 78.156, 102.573, 103.286, 115.554, 121.353, 152.176, 155.072
IR (KBr) (cm⁻¹): 3570, 3196, 2916, 2850, 2206, 1628, 1508, 1488, 1408, 1392, 1376, 1262, 1204, 1096, 1052, 1028, 892, 858, 794, 722, 668

### Example 3. Evaluation of TNT detection by the polymer of formula (1a) of the invention

The polymer of formula (1a) obtained in Example 1 was tested in order to verify its capability to detect TNT.

100 µl of a solution of polymer (1a) (0.1 mg/ml) in DMF were deposited on a 2.5x2.5 cm glass substrate for microscope examination, which was rotated at 6000 rpm for 50 seconds. The resulting film was placed under vacuum for 20 minutes so as to obtain a substrate slightly coloured and completely free of the starting solvent. The obtained film was cut, so as to allow its placement into a quartz fluorometer cuvette having a 1 cm optical path.

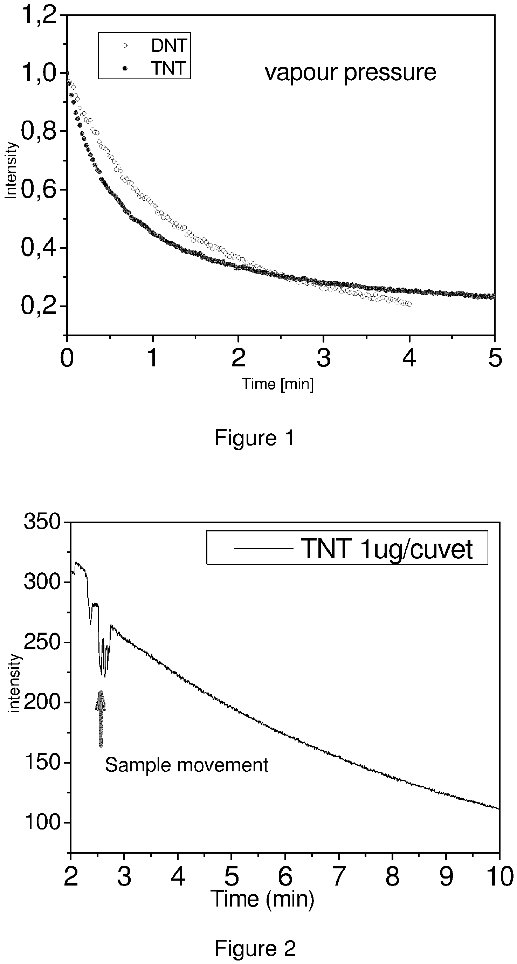

The measurements reported in Figure 1 were performed by placing 1 mg of TNT or DNT in a cuvette with the active material and then measuring the decrease in fluorescence intensity over time with a fluorometer (a Cary eclipse). The measurements in Figure 2 were performed under similar experimental conditions, with the difference being that the mass of TNT was measured exactly (1 µg). Specifically, 1 µl of standard TNT solution in certified acetonitrile (Aldrich), containing exactly 1 mg/ml of TNT, was taken through an automatic micro-pipette with a polyethylene tip. Said solution was then evaporated under nitrogen stream and vacuum-dried for 5 minutes directly in the tip. The tip so prepared and whereon approximately 1 µg of TNT was deposited, was placed inside the cuvette. At this point, the fluorescence intensity was monitored at 475 nm while exciting the film at 420 nm.

Thus, it was possible to appreciate the gradual quenching of the polymer's fluorescence, which amounted to 50% of the initial fluorescence in 5 minutes; therefore, said experiment shows how efficient the sensor is with respect to TNT vapours, even when deriving from only 1 µg of this substance.

### Example 4. Preparation of the polymer of formula (2a) of the invention

The preparation and the characterization of the polymer of formula (2a) is reported herein below:

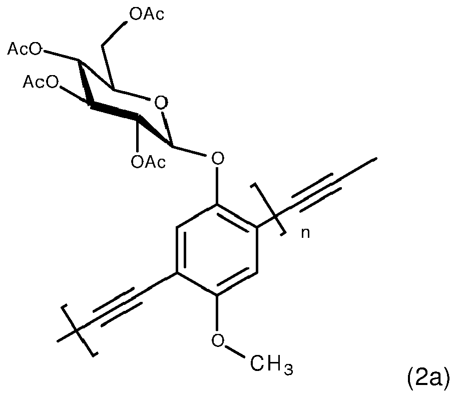

### - Synthesis of 2,5-diiodo-4-methoxy phenol:

2,5-diiodo-1,4-dimethoxy-benzene (4 g, 10.2 mmol) was dissolved in anhydrous CH₂Cl₂ (80 ml) and then 10.2 ml of BBr₃ 1 M in methylene chloride were added at 0°C. The resulting solution was stirred at room temperature for 6 hours. The reaction was stopped by adding a 10% HCl solution, subsequently the organic phase was extracted by using EA (250 +250 ml), then anhydrified on Na₂SO₄ and evaporated to dryness (rotavapor). The crude product was purified by chromatography on silicon dioxide gel by using PE / DCM (2:3) as an eluent to obtain 2.64 g (70% yield) of a white solid.
Rf = (3:2 MC/PE) 0.35
¹H-NMR (400 MHz, CDCl₃) (ppm): 3.81 (s, 3.2 H), 4.95 (s, 1 H), 7.03 (s, 1 H), 7.41 (s, 1 H)
¹³C-NMR (100 MHz, CDCl₃) (ppm): 57.13, 84.4, 86.7, 119.5, 124.9, 149.9, 152.9 EI-MS (M/Z): 376(M+, 100%), 361(58%), 333(10%), 234(24%)

### - Synthesis of (4-methoxy-2,5-diiodo-phenoxy)-trimethyl-silane:

2,5-diiodo-4-methoxy phenol (2.5 g, 6.65 mmol) and 1,1,1,3,3,3-hexamethyl disilazane (1.5 ml, 7.26 mmol) were dissolved in 15 ml of anhydrous acetonitrile and the solution was stirred vigorously for 10 minutes, then chlorotrimethylsilane (930 µl, 7.26 mmol) was added and the reaction mixture was further stirred under nitrogen at room temperature for 16 h. The reaction was processed by removing the solvent under low pressure and the residue was dissolved in petroleum ether and filtered in order to eliminate the precipitated salts. The solution was washed with aqueous sodium bicarbonate and the organic extracts were anhydrified on Na₂SO₄ and then concentrated at a low pressure and vacuum-dried. 2.91 g (98% yield) of product, which did not require further purification, were obtained.
¹H-NMR (400 MHz, CDCl3) δ(ppm): 0.308 (s, 9 H), 3.81 (s, 3.2 H), 7.136 (s, 1 H),
7.212 (s, 0.95 H)
¹³C-NMR (100 MHz, CDCl3) δ(ppm): 0.461, 56.98, 90.26, 120.6, 128.7, 153.5

### - (2,3,4,6-tetra-O-acetyl-β-D-glucopyranosyl)-2,5-diiodo-4-methoxybenzene:

β-D-glucose pentaacetate (2.4 g, 6.16 mmol) was dissolved in 40 ml of anhydrous dichloromethane and then a solution of BF3 • Et2O (5.6 ml) and subsequently the (4-methoxy-2,5-diiodo-phenoxy)-trimethylsilane (2.5 g, 5.6 mmol) were added in 10 ml of CH₂Cl₂ under nitrogen at rt. After 16 h, the reaction mixture was washed with a bicarbonate and water solution and anhydrified on anhydrous Na₂SO₄. After low-pressure evaporation of the solvent, the crude product was purified by methanol crystallization, thus obtaining 2.4 g (60% yield) of a white solid.
mp: 195-198°C
¹H-NMR (400 MHz, CDCl₃) δ(ppm): 2.01 (s, 3.0 H), 2.03 (s, 3.0 H), 2.08 (s, 3.1 H), 2.15 (s, 3.2 H), 3.10 (s, 3.6 H), 3.87 (comp, 0.96 H), 4.197 (comp, 2.0), 4.92 (d, J=7.5, 1.01 H), 5.1 (comp, 1 H), 5.29 (comp, 2.3), 7.12 (s, 1.0 H), 7.48 (s, 1.0 H)
¹³C-NMR (100 MHz, CDCl₃) δ(ppm): 20.5, 21.0, 21.17, 56.96, 62.18, 68.23, 70.59, 72.2, 72.4, 85.27, 86.8, 100.2, 120.7, 127.1, 150.7, 154.9, 169.1, 169.4, 170, 170.6

### - (2,3,4,6-tetra-O-acetyl-β-D-glucopyranosyl)-2,5-bis(trimethylsilylethynyl)-4-methoxybenzene:

(Trimethyilsilyl)acetilene (705 µl, 5.00 mmol) and triethylamine (1.8 ml, 13.3 mmol) were added at rt to a stirred solution of (2,3,4,6-tetra-O-acetyl-β-D-glucopyranosyl)-2,5-diiodo-4-methoxybenzene (1 g, 1.38 mmol) in 25 ml of anhydrous THF. Then, the catalyst Pd(PPh₃)₄ (96 mg, 0.083 mmol) and Cul (20 mg, 0.1 mmol) were added. After 48 hours, the reaction mixture was extracted with EA and washed with saturated NH₄Cl and then anhydrified on anhydrous Na₂SO₄. After low-pressure evaporation of the solvent, the crude product obtained was purified by chromatography on a silicon dioxide gel, by using petroleum ether and ethyl acetate (7:3) as eluents, thus obtaining 0.760 g (83% yield) of a yellow solid.
¹H-NMR (400 MHz, CDCl₃) δ(ppm): 0.25 (s, 18. H), 2.02, 2.04, 2.05, 2.11 (s, 12.2 H), 3.83 (s, 3.1H), 3.92 (comp, 1.0 H), 1.78 (dd, J=2.2, J=12.2 Hz, 1.1 H), 4.26 (dd, J=6.3, J=12.1 Hz, 1.1 H), 5.11 (comp, 2.1 H), 5.28 (comp, 2.1 H), 6,88 (s, 1 H), 7.0 (s, 1 H), 6.85 (s, 1.1 H), 6.98 (s, 1.1 H)
¹³C-NMR (100 MHz, CDCl₃) δ(ppm): 170.607, 170.229, 169.408, 168.938, 155.749, 150.817, 120.159, 115.623, 114.924, 113.391, 100.840, 100.354, 99.519, 99.019, 72.824, 72.050, 70.927, 68.347, 62.113, 56.341, 20.782, 20.613, - 0.039, -0.161

### - Synthesis of polymer (2a):

(2,3,4,6-tetra-O-acetyl-β-D-glucopyranosyl)-2,5-diiodo-4-methoxybenzene (0.75 g, 1.04 mmol), Ag₂O (480 mg, 2.8 mmol), (2,3,4,6-tetra-O-acetyl-β-D-glucopyranosyl)-2,5-bis(trimethylsilylethynyl)-4-methoxybenzene (0.65 g, 1.04 mmol) and Pd(PPh₃)₄ (120 g, 0.10 mmol) were dissolved in 25 ml of anhydrous THF under nitrogen. The mixture was stirred at 60°C for 72 hours and the brown solid dissolved in DMF was filtered on celite to remove Ag₂O in excess. After low-pressure evaporation of the solvent, the crude product was purified using a Soxhlet extractor with methanol for 6 hours, to eliminate the low molecular weight fractions, and subsequently re-dissolved in DMF and finally subjected to centrifugation (10000 rpm, 20 min), thus obtaining a green vacuum-dried solid (790 mg, 80% yield).
¹H-NMR (400 MHz, DMF-d7) (ppm): 0.833 (s, 3.3 H), 1.24÷1.55 (comp, 10 H), 1.85÷2.01 (comp, 12 H), 3.98÷4.6 (comp, 3.9 H), 5.0÷5.6 (comp, 3.5), 6.88÷7.4 (comp, 2 H)
¹³C-NMR (100 MHz, DMF-d7) (ppm): 56.361, 56.481, 61.766, 62.248, 68.836, 71.935, 72.080, 72.480, 90.275, 97.256, 98.808, 113.409, 113.549, 119.546, 150.926, 155.411, 169.991, 170.405

### Example 5. Preparation of the polymer of formula (2b) of the invention

The preparation and the characterization of the polymer of formula (2b) is reported herein below:

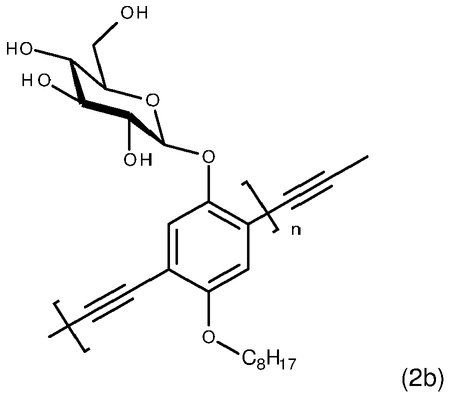

A catalytic amount of metallic sodium (5 mg, 5%) was dissolved in 3 ml of MeOH and then the polymer of formula (2a) (0.100 g) was added. The mixture was stirred at room temperature for 96 h. The solution was filtered and washed with fresh MeOH and the solid was vacuum-dried and dissolved in 1.4 ml of DMF d-7 to obtain the centrifuged (10000 rpm, 20 min) mother solution of polymer (2b).
¹H-NMR (400 MHz, DMF-d7) δ(ppm): 0.868 (3.7 H), 1.29 (9.2), 1.56 (1.7 H), 1.87 (1.7 H), 3.43÷4.152 (14.9 H), 4.8÷5.4 (4.5 H), 7.1÷7.6 (4 H)
¹³C-NMR (100 MHz, DMF-d7) δ(ppm): 49.043, 56.362, 61.716, 70.620, 74.457, 77.653, 102.381, 114.985, 121.518, 151.838, 155.278

From the detailed description and the Examples above reported, the advantages achieved by the polymer of the present invention are evident. In fact, it was possible not only to avoid the problem of self-quenching, but also to obtain a polymer showing optimal optical properties and an extremely low level of toxicity, since the glucose substituent is undoubtedly much less harmful for health compare to the substituents used until now in the known techniques.

## Claims

1. Polymer of formula (I): 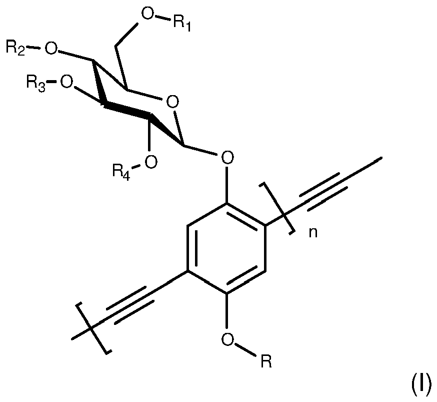 an enantiomer or a diastereoisomer thereof,
wherein n is an integer higher than 2,
R is a linear or branched C₁-C₂₀ alkyl group, and
R₁, R₂, R₃, and R₄ are, independently of each other, H, a C₁-C₃ alkyl group or acetate (Ac).

2. The polymer of claim 1, wherein R is a linear or branched C₁-C₁₆ alkyl group.

3. The polymer of claim 2, wherein R is a linear or branched C₁-C₁₂ alkyl group.

4. The polymer of any one of claims 1-3, of formula (Ia):

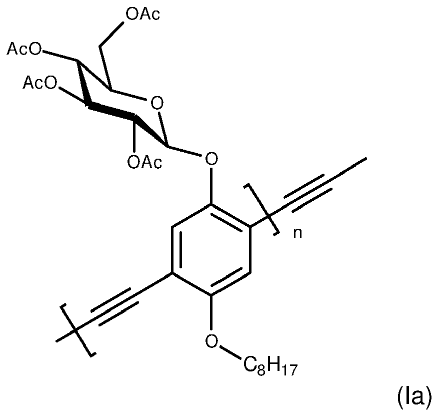

5. The polymer of claim 4, of formula (1a):

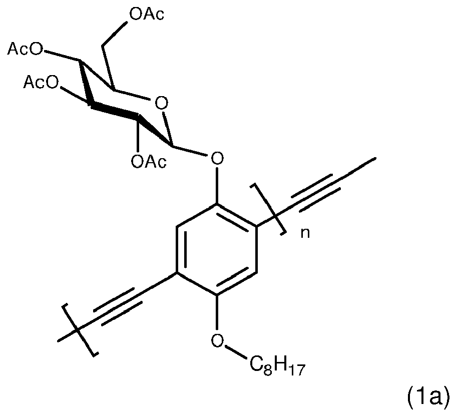

6. The polymer of claim 4, of formula (2a):

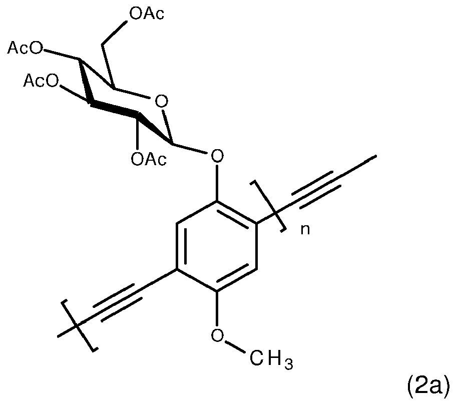

7. The polymer of claim 4, of formula (3a):

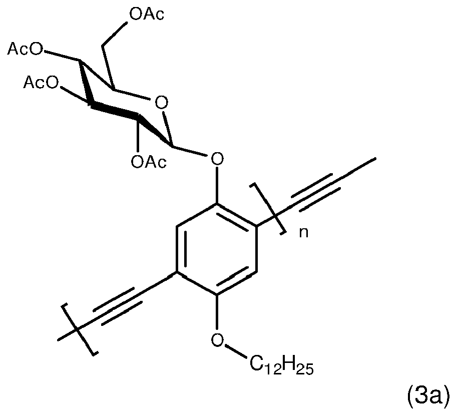

8. The polymer of any one of claims 1-3, of formula (Ib):

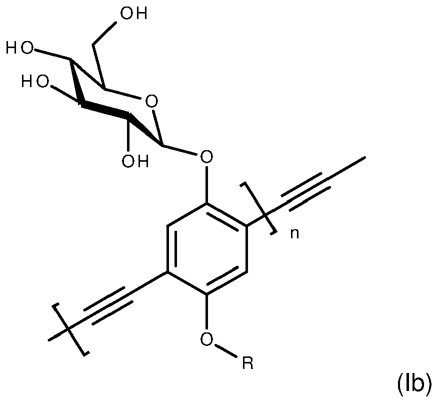

9. The polymer of any one of claims 1-3, of formula (Ic):

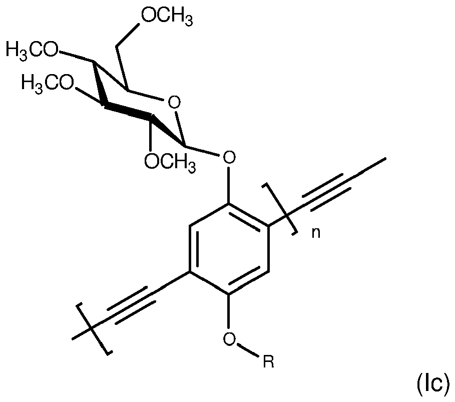

10. The polymer of claim 9, of formula (1c):

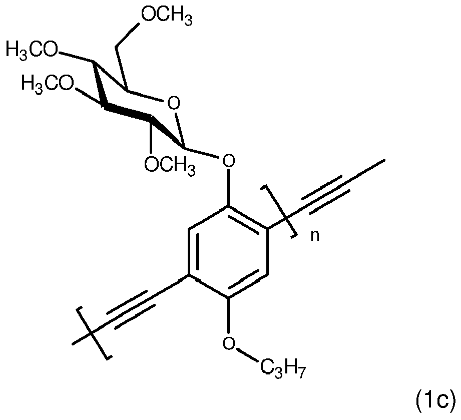

11. The polymer of claim 9, of formula (2c):

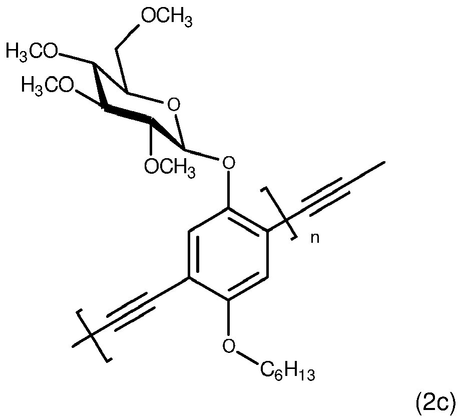

12. The polymer of claim 9, of formula (3c):

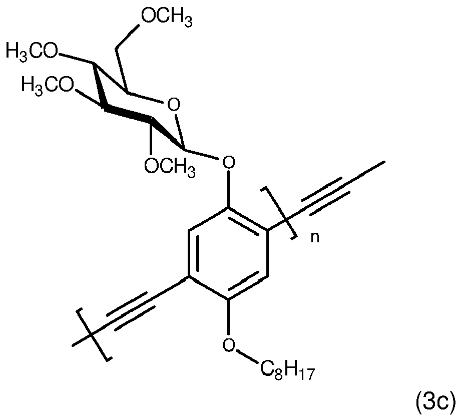

13. Use of the polymer of formula (I) of claim 1 in fluorescence-quenching sensors.

14. The use of claim 13 in fluorescence-quenching sensors for the detection of TNT.

15. Use of the polymer of formula (I) of claim 1 in organic light-emitting electroluminescent devices (OLEDs).
